# EUROPÄISCHE PATENTSCHRIFT

(11) **EP 2 954 141 B1**
(45) Veröffentlichungstag und Bekanntmachung des Hinweises auf die Patenterteilung: **22.03.2017**
(21) Anmeldenummer: 13783832.2
(22) Anmeldetag: 31.07.2013
(51) Int. Cl.: H01L 31/0392, E06B 9/24, E06B 9/264, H02S 30/20

(54) **ELASTISCHES BESCHATTUNGSTEXTIL MIT PHOTOVOLTAIKELEMENTEN UND EINE ENTSPRECHENDE MEHRFACHVERGLASUNG**
ELASTIC SHADING TEXTILE COMPRISING PHOTOVOLTAIC ELEMENTS, AND CORRESPONDING MULTIPLE GLAZING
TEXTILE D'OMBRAGE ÉLASTIQUE DOTÉ D'ÉLÉMENTS PHOTOVOLTAÏQUES ET VITRAGE MULTIPLE CORRESPONDANT

(30) Priorität: 11.02.2013 DE 102013101310
(43) Veröffentlichungstag der Anmeldung: 16.12.2015
(73) Patentinhaber: Penn Textile Solutions GmbH, 33102 Paderborn (DE)
(72) Erfinder: JASPER, Leo, NL-6417 AZ Heerlen (NL); SCHÜTTE, Franz, 33100 Paderborn (DE)
(74) Vertreter: Angerhausen, Christoph
(86) Internationale Anmeldenummer: PCT/DE2013/000422
(87) Internationale Veröffentlichungsnummer: WO 2014/121765

(56) Entgegenhaltungen:
- WO-A1-00/55465
- WO-A1-2010/133279
- DE-A1- 19 752 162
- DE-A1-102010 022 059
- DE-U1-202004 014 182
- US-A1- 2011 048 656
- US-A1- 2012 152 469

## Beschreibung

Die Erfindung betrifft ein elastisches Beschattungstextil mit Photovoltaikelementen und eine entsprechende Mehrfachverglasung. Ein gattungsgemäßes Beschattungstextil ist aus der DE 10 2010 022 059 A1 bekannt und dient neben der Beschattung von Wohngebäuden beispielsweise auch der Beschattung von Gewächshäusern, um optimale klimatische Bedingungen für die Pflanzenzucht zu schaffen.

Die US 2011/048656 A1 beschreibt ein Beschattungstextil, das eine Mehrzahl streifenförmiger Photovoltaiklamellen aufweist, die über ein Garnsystem entlang ihrer Längsrichtung aneinander gereiht oder voneinander beabstandet ein fortlaufendes Produkt bilden, wobei das Garnsystem in zumindest einer Richtung elastisch ausgebildet ist, so dass durch Verspannen des Beschattungstextils ein Abstand senkrecht zu der Längsrichtung zwischen benachbarten Photovoltaiklamellen variierbar ist. Ähnliche Vorrichtungen sind auch aus der DE 20 2004 014182 U1, der WO 00/55465 A1, der US 2012/152469 A1, der DE 197 52 162 A1 und der WO 2010/133279 A1 bekannt.

Insbesondere in der Gewächshausbeschattung ist es wünschenswert, die Beschattungseinrichtung in einer Weise auszubilden, dass diese zumindest dann, wenn sie zur Beschattung eines Gewächshauses dient, zumindest anteilig zur Deckung des Energiebedarfs des Gewächshauses beiträgt. Zu diesem Zwecke ist aus der DE 20 302 826 U1 eine Lamellenjalousie bekannt, welche zwischen den Glasscheiben einer Doppelverglasung angeordnet ist, wobei Photovoltaikelemente auf den Lamellen angeordnet sind. Eine derartige Lamellenjalousie hat jedoch den Nachteil, dass immer dann keine elektrische Energie gewonnen werden kann, wenn die Lamellen parallel zur Sonneneinfallsrichtung ausgerichtet sind, um den Einfall des Sonnenlichts in das Gewächshaus zu ermöglichen.

Es ist daher die Aufgabe der Erfindung, ein gattungsgemäßes Beschattungstextil und eine entsprechende Mehrfachverglasung derart fortzuentwickeln, dass diese auch dann für die Gewinnung elektrischer Energie verwendet werden können, wenn nicht beschattet werden soll.

Diese Aufgabe wird erfindungsgemäß durch ein Beschattungstextil mit den Merkmalen des Anspruchs 1 und eine entsprechende Mehrfachverglasung mit den Merkmalen des Anspruchs 11 gelöst. Die abhängigen Ansprüche 2 bis 10 sowie 12 und 13 entsprechen jeweils vorteilhaften Ausführungsformen der Erfindung.

Das erfindungsgemäße Beschattungstextil zeichnet sich dadurch aus, dass es in einem verspannten Zustand Öffnungen zwischen den benachbarten Photovoltaiklamellen aufweist, die sich erst beim Verspannen des Beschattungstextils ausbilden, oder die von den Photovoltaiklamellen verdeckt sind, wenn das Beschattungstextil unverspannt ist. Das erfindungsgemäße Beschattungstextil hat gegenüber den aus dem Stand der Technik bekannten Beschattungstextilien den Vorteil, dass die Photovoltaikelemente während der Verspannung des Beschattungstextils nicht ihre Ausrichtung ändern und somit unabhängig davon, in welcher Betriebsstellung sich das Beschattungstextil befindet, stets zur Gewinnung elektrischer Energie zur Verfügung stehen.

Bei einer einfachsten Ausführungsform der Erfindung sind die Photovoltaikelemente daher in einer relaxierten Stellung des Garnsystems unmittelbar aneinander gereiht angeordnet, so dass sie eine im Wesentlichen vollständige Beschattung bewirken. Durch Verspannen des Garnsystems werden die Photovoltaikelemente voneinander beabstandet, so dass durch sich zwischen den Photovoltaikelementen im Zuge des Verspannens ausbildende Lücken Licht hindurchfallen kann. Alternativ oder zusätzlich kann das Garnsystem jedoch auch Öffnungen aufweisen, die bei nicht verspanntem Beschattungstextil geschlossen sind und sich erst beim Verspannen des Beschattungstextils öffnen, um Licht durchzulassen.

Bei einer Ausführungsform der Erfindung ist das Garnsystem in Kettrichtung des Beschattungstextils dehnbar, wobei die Photovoltaiklamellen in Schussrichtung verlaufen, so dass bei einer Verspannung des Garnsystems in Kettrichtung die Photovoltaiklamellen gerade in Richtung senkrecht zur Längserstreckung der Photovoltaiklamellen voneinander entfernt werden.

Um eine elektrische Kontaktierung der Photovoltaiklamellen zu erreichen, ist bei einer Ausführungsform der Erfindung vorgesehen, dass das Garnsystem in Kettrichtung verlaufende, voneinander beabstandete Stränge aus mindestens einem Faden aufweist, wobei mindestens ein Faden je Strang elektrisch leitfähig ist. Dabei kann vorgesehen sein, dass auf mindestens einer der Photovoltaiklamellen zwischen jeweils benachbarten Strängen ein Photovoltaikelement angeordnet ist.

Für die elektrische Kontaktierung der Photovoltaiklamellen bzw. von Photovoltaikelementen, welche auf den Photovoltaiklamellen ausgebildet sind, ist bei einer anderen Ausführungsform vorgesehen, dass die Photovoltaiklamellen mindestens eine in Schussrichtung verlaufende Folie aus einem elektrisch leitfähigen Material aufweisen, wobei mindestens ein Photovoltaikelement auf der Photovoltaiklamelle mit der Folie elektrisch in Kontakt steht.

Alternativ zu der zuletzt genannten Ausführungsform ist bei einer anderen Ausführungsform vorgesehen, dass die Photovoltaiklamelle ein textiles Band mit mindestens einem in Schussrichtung des Beschattungstextils verlaufenden, elektrisch leitfähigen Faden oder Garn aufweist, wobei mindestens ein Photovoltaikelement auf der Photovoltaiklamelle mit dem elektrisch leitfähigen Faden oder Garn elektrisch in Kontakt steht.

Erfindungsgemäß können sowohl organische als auch anorganische Solarfolien als Schussfäden in das Beschattungstextil bzw. das Beschattungsgewirk eingebracht werden. Bei einem besonders kompakt und leicht bauenden Beschattungstextil sind die Photovoltaiklamellen elastisch verformbare Photovoltaikfolien oder sie weisen solche auf. Dazu eignen sich beispielsweise sogenannte CIGS-Polymersolarzellen.

Bei einer anderen Ausführungsform weisen die Photovoltaiklamellen jeweils eine Trägerlamelle auf, auf der eine Photovoltaikfolie befestigt, beispielsweise aufgeklebt, ist. Dabei kann die Photovoltaikfolie die Trägerlamelle von einer Oberseite der Trägerlamelle um gegenüber liegende Längskanten der Trägerlamelle herum zu einer Unterseite der Trägerlamelle umspannen.

Um zu gewährleisten, dass die Öffnungen im unverspannten Zustand des Beschattungstextils geschlossen sind, ist das Garnsystem in der Richtung, in welcher das Beschattungstextil elastisch ausgebildet ist, elastisch verspannbar, und weist eine dieser Richtung entgegen gesetzte Vorspannung auf, so dass Öffnungen, die sich erst beim Verspannen des Beschattungstextils ausbilden sollen, geschlossen sind, wenn das Beschattungstextil unverspannt ist.

Bei der erfindungsgemäßen Mehrfachverglasung ist ein Beschattungstextil der zuvor beschriebenen Art in einem Scheibenzwischenraum aufgenommen.

Eine einfache Bedienung des Beschattungstextils und ein gleichzeitig wartungsfreier Aufbau dieses kann dadurch erreicht werden, dass das Beschattungstextil in der Richtung, in welcher es elastisch ausgebildet ist, in dem Scheibenzwischenraum zwischen einer ersten und einer zweiten Stellung linear geführt ist, wobei an einem beweglichen Zugende des Beschattungstextils, das gegenüber von einem unbeweglichen Festende des Beschattungstextils angeordnet ist, ein erster Magnet und außerhalb des Scheibenzwischenraums ein zweiter Magnet angeordnet ist, wobei die Magnete wirkgekoppelt sind.

Eine möglichst einfache Bedienung des Beschattungstextils kann dadurch erreicht werden, dass der zweite Magnet entlang einer Linearführung in der Richtung, in welcher das Beschattungstextil elastisch ausgebildet ist, verschiebbar ist.

Beispielhafte Ausführungsformen werden anhand der nachstehenden Figuren erläutert. Dabei zeigt:
- Figur 1: eine erste Ausführungsform des erfindungsgemäßen Beschattungstextils mit einer eine elektrisch leitfähige Folie aufweisenden Photovoltaiklamelle; und
- Figur 2: eine zweite Ausführungsform des erfindungsgemäßen Beschattungstextils mit einer ein leitfähiges, textiles Band aufweisenden Photovoltaiklamelle.

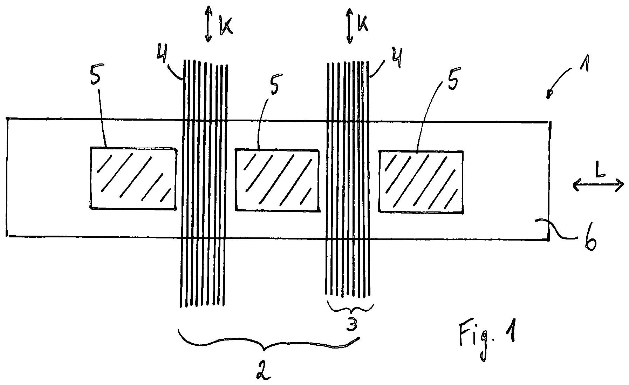

Bei dem in Figur 1 gezeigten Ausschnitt aus einem erfindungsgemäßen Beschattungstextil einer ersten Ausführungsform ist das Garnsystem 2 aus einer Mehrzahl parallel beabstandeter Stränge 3 ausgebildet, wobei jeder Strang 3 wiederum aus einer Mehrzahl Fäden 4 aufgebaut ist. Obwohl in den Figuren die Fäden 4 schematisch parallel verlaufend dargestellt sind, soll das erfindungsgemäße Garnsystem 2 insbesondere auch Stränge aus gewebten oder gewirkten Fäden 4 umfassen. Die Stränge 3 verlaufen in Kettrichtung des Beschattungstextils 1, während die Photovoltaiklamelle 1 als Schussfäden in das Garnsystem 2 eingebracht sind, so dass sich die Längsrichtung L der Photovoltaiklamellen 1 gerade in Schussrichtung, d. h. senkrecht zur Kettrichtung K des Garnsystems 2 erstrecken. Zwischen den parallel beabstandeten Strängen 3 sind Photovoltaikelemente 5 auf den Photovoltaiklamellen 1 aufgebracht. Die Photovoltaikelemente 5 können Photovoltaikfolien sein, welche auf einer Trägerlamelle aufgebracht sind. Bei der Ausführungsform gemäß Figur 1 sind die Photovoltaikelemente 5 auf einer Aluminiumfolie 6 aufgebracht, um diese zu kontaktieren. Darüber hinaus weisen die Stränge 3 elektrisch leitfähige Fäden auf, über welche die Photovoltaikelemente 5 elektrisch kontaktierbar sind. Mit Hilfe der elektrisch leitfähigen Folie 6 der Photovoltaiklamellen 1 sowie mit Hilfe der elektrisch leitfähige Fäden aufweisenden Stränge 3 ist somit eine aktive Matrix ausgebildet, über welche jedes einzelne Photovoltaikelement 5 individuell ansteuerbar bzw. auslesbar ist.

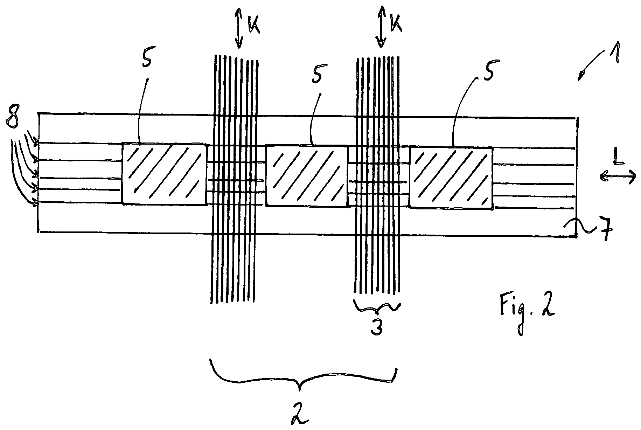

Das in Figur 2 gezeigte Beschattungstextil unterscheidet sich von dem in Figur 1 gezeigten darin, dass die Photovoltaiklamelle 1 anstelle einer elektrisch leitfähigen Folie ein textiles Band 7 aufweist, welches mindestens einen in Schussrichtung K verlaufenden, elektrisch leitfähigen Faden 8 aufweist. Der elektrisch leitfähige Faden 8 erstreckt sich über die gesamte Länge des textilen Bandes 7, wobei sämtliche der Photovoltaikelemente 5 einer Photovoltaiklamelle 1 über den Faden 8 kontaktiert sind. Zusammen mit den Strängen 3, welche wiederum mindestens einen elektrisch leitfähigen Faden aufweisen, bilden die textilen Bänder 7 der Photovoltaiklamelle eine aktive Matrix zur individuellen Ansteuerung der Photovoltaikelemente 5.

Zur Vereinfachung der Darstellung sind in den Figuren 1 und 2 lediglich Ausschnitte des erfindungsgemäßen Beschattungstextils gezeigt. Das fertige Produkt weist in Längsrichtung L der Photovoltaiklamellen 1 eine Vielzahl Photovoltaikelemente 5 sowie eine Vielzahl parallel beabstandeter Stränge 3 auf. Die Anzahl der Stränge 3 sowie die Länge der Photovoltaiklamellen 1, und dementsprechend die Anzahl der Photovoltaikelemente 5, ist auf keine bestimmte Anzahl beschränkt. Ebenso setzt sich das in den Figuren gezeigte jeweilige Produkt in Kettrichtung K durch parallele Aneinanderreihung einer Vielzahl streifenförmiger Photovoltaiklamellen 1 fort. Da die Stränge 3 in Kettrichtung K elastisch sind, kann durch Verspannung des Beschattungstextils in Kettrichtung K der Abstand benachbarter Photovoltaiklamellen 1 vertikal zur Längsrichtung der Photovoltaiklamellen 1 variiert werden.

### Bezugszeichenliste

- 1: Photovoltaiklamellen
- 2: Garnsystem
- 3: Strang
- 4: Faden
- 5: Photovoltaikelement
- 6: Folie
- 7: textiles Band
- 8: elektrisch leitfähiger Faden
- K: Kettrichtung des Beschattungstextils
- L: Schussrichtung des Beschattungstextils

## Patentansprüche

1. Beschattungstextil, das eine Mehrzahl streifenförmiger Photovoltaiklamellen (1) aufweist, die über ein Garnsystem (2) entlang ihrer Längsrichtung (L) aneinander gereiht oder voneinander beabstandet ein fortlaufendes Produkt bilden, wobei das Garnsystem (2) in zumindest einer Richtung (K) elastisch ausgebildet ist, so dass durch Verspannen des Beschattungstextils ein Abstand senkrecht zu der Längsrichtung (L) zwischen benachbarten Photovoltaiklamellen (1) variierbar ist, **dadurch gekennzeichnet, dass** das Beschattungstextil in einem verspannten Zustand Öffnungen zwischen den benachbarten Photovoltaiklamellen aufweist, die sich erst beim Verspannen des Beschattungstextils ausbilden, oder die von den Photovoltaiklamellen (1) verdeckt sind, wenn das Beschattungstextil unverspannt ist.

2. Beschattungstextil nach Anspruch 1, bei dem das Garnsystem (2) in Kettrichtung (K) dehnbar ist, wobei die Photovoltaiklamellen (1) in Schussrichtung (L) verlaufen.

3. Beschattungstextil nach Anspruch 1 oder 2, bei dem das Garnsystem (2) in Kettrichtung (K) verlaufende, voneinander beabstandete Stränge (3) aus mindestens einem Faden (4) aufweist, wobei mindestens ein Faden (4) je Strang elektrisch leitfähig ist.

4. Beschattungstextil nach Anspruch 3, bei dem auf mindestens einer der Photovoltaiklamellen (1) zwischen jeweils benachbarten Strängen (3) ein Photovoltaikelement (5) angeordnet ist.

5. Beschattungstextil nach einem der vorangegangenen Ansprüche, bei dem die Photovoltaiklamellen (1) mindestens eine in Schussrichtung (L) verlaufende Folie (6) aus einem elektrisch leitfähigen Material aufweisen, wobei mindestens ein Photovoltaikelement (5) auf der Photovoltaiklamelle (1) mit der Folie (6) elektrisch in Kontakt steht.

6. Beschattungstextil nach einem der Ansprüche 1 bis 4, bei dem die Photovoltaiklamelle (1) ein textiles Band (7) mit mindestens einem in Schussrichtung (K) des Beschattungstextils verlaufenden, elektrisch leitfähigen Faden (8) aufweist, wobei mindestens ein Photovoltaikelement (5) auf der Photovoltaiklamelle (1) mit dem elektrisch leitfähigen Faden (8) elektrisch in Kontakt steht.

7. Beschattungstextil nach einem der vorangegangenen Ansprüche, bei dem die Photovoltaiklamellen (1) elastisch verformbare Photovoltaikfolien aufweisen.

8. Beschattungstextil nach einem der vorangegangenen Ansprüche, bei dem die Photovoltaiklamellen (1) jeweils eine Trägerlamelle aufweisen, auf der mindestens eine Photovoltaikfolie befestigt, beispielsweise aufgeklebt ist.

9. Beschattungstextil nach Anspruch 8, bei dem die Photovoltaikfolie die Trägerlamelle von einer Oberseite der Trägerlamelle um gegenüber liegende Längskanten der Trägerlamelle herum zu einer Unterseite der Trägerlamelle umspannt.

10. Beschattungstextil nach einem der vorangegangenen Ansprüche, bei dem das Garnsystem (2) in der Richtung, in welcher das Beschattungstextil elastisch ausgebildet ist, elastisch verspannbar ist und eine dieser Richtung entgegen gesetzte Vorspannung aufweist, so dass Öffnungen, die sich erst beim Verspannen des Beschattungstextils ausbilden, geschlossen sind, wenn das Beschattungstextil unverspannt ist.

11. Mehrfachverglasung, bei der ein Beschattungstextil nach einem der vorangegangenen Ansprüche in einem Scheibenzwischenraum aufgenommen ist.

12. Mehrfachverglasung nach Anspruch 11, bei dem das Beschattungstextil in der Richtung, in welcher es elastisch ausgebildet ist, in dem Scheibenzwischenraum zwischen einer ersten und einer zweiten Stellung linear geführt ist, wobei an einem Zugende des Beschattungstextils ein erster Magnet und außerhalb des Scheibenzwischenraums ein zweiter Magnet angeordnet ist, wobei die Magnete wirkgekoppelt sind.

13. Mehrfachverglasung nach einem der Ansprüche 11 oder 12, bei dem der zweite Magnet entlang einer Linearführung in der Richtung, in welcher das Beschattungstextil elastisch ausgebildet ist, verschiebbar ist.

## Claims

1. A shading textile, comprising a plurality of strip-shaped photovoltaic lamellas (1) which, aligned next to one another or spaced apart from one another in their longitudinal direction (L), form a continuous product by means of a yarn system (2), wherein the yarn system (2) is designed to be elastic in at least one direction (K), so that by tensioning the shading textile, a spacing between adjacent photovoltaic lamellas (1) can be varied perpendicular to the longitudinal direction (L), **characterized in that** the shading textile, in a tensioned state, comprises openings between the adjacent photovoltaic lamellas which form only when the shading textile is tensioned, or which are covered by the photovoltaic lamellas (1) when the shading textile is not tensioned.

2. The shading textile according to claim 1, in which the yarn system (2) can be stretched in the warp direction (K), wherein the photovoltaic lamellas (1) extend in the weft direction (L).

3. The shading textile according to claim 1 or 2, in which the yarn system (2) comprises strands (3) made of at least one thread (4), which extend in the warp direction (K) spaced apart from one another, wherein at least one thread (4) per strand is electrically conductive.

4. The shading textile according to claim 3, in which, on at least one of the photovoltaic lamellas (1), a photovoltaic element (5) is arranged between respective adjacent strands (3).

5. The shading textile according to one of the preceding claims, in which the photovoltaic lamellas (1) comprise at least one film (6) made of an electrically conductive material and extending in the weft direction (L), wherein at least one photovoltaic element (5) on the photovoltaic lamella (1) is in electrical contact with the film (6).

6. The shading textile according to one of the claims 1 to 4, in which the photovoltaic lamella (1) comprises a textile web (7) with at least one electrically conductive thread (8) extending in the weft direction (L) of the shading textile, wherein at least one photovoltaic element (5) on the photovoltaic lamella (1) is in electrical contact with the electrically conductive thread (8).

7. The shading textile according to one of the preceding claims, in which the photovoltaic lamellas (1) comprise elastically deformable photovoltaic films.

8. The shading textile according to one of the preceding claims, in which the photovoltaic lamellas (1) each comprise a support lamella to which the at least one photovoltaic film is attached, for example glued.

9. The shading textile according to claim 8, in which the photovoltaic film spans the support lamella from a top side of the support lamella around facing longitudinal edges of the support lamella to an underside of the support lamella.

10. The shading textile according to one of the preceding claims, in which the yarn system (2) can be tensioned elastically in the direction in which the shading textile is formed elastically, and it has a pretensioning in the direction opposite said direction, so that openings that form only when the shading textile is tensioned are closed when the shading textile is not tensioned.

11. A multiple glazing product, in which a shading textile according to the preceding claims is accommodated in an interstice between two panes.

12. The multiple glazing product of claim 11, in which the shading textile, in the direction in which it is formed elastically, is guided linearly in the interstice between the panes, between a first and a second position, wherein, at a pulling end of the shading textile, a first magnet is arranged, and, outside of the interstice between the panes, a second magnet is arranged, wherein the magnets are operatively connected.

13. The multiple glazing product of claim 11 or 12, in which the second magnet can be moved along a linear guide in the direction in which the shading textile is formed elastically.

## Revendications

1. Textile d'ombrage qui comprend une pluralité de lamelles photovoltaïques (1) en forme de bandes, qui constituent, alignées ou éloignées entre elles un produit continu grâce à un système de fils (2) le long de leur extension longitudinale (L), le système de fils (2) étant réalisée de manière élastique dans au moins une direction (K), de façon à ce qu'une tension du textile d'ombrage permette de faire varier une distance perpendiculaire à l'extension longitudinale (L) entre des lamelles photovoltaïques (1) adjacentes, **caractérisé en ce que** le textile d'ombrage comprend, dans un état tendu, des ouvertures entre les lamelles photovoltaïques adjacentes, qui ne se forment que lors de la tension du textile d'ombrage ou qui sont recouvertes par les lamelles photovoltaïques (1) lorsque le textile d'ombrage n'est pas tendu.

2. Textile d'ombrage selon la revendication 1, dans lequel le système de fils (2) est extensible dans la direction de la chaîne (K), les lamelles photovoltaïques (1) s'étendant dans la direction de la trame (L).

3. Textile d'ombrage selon la revendication 1 ou 2, dans lequel le système de fils (2) comprend des brins (3) s'étendant dans la direction de la chaîne (K), éloignées entre eux, composés d'au moins un fil (4), au moins un fil (4) par brin étant électriquement conducteur.

4. Textile d'ombrage selon la revendication 3, dans lequel au moins une des lamelles photovoltaïques (1), entre des brins (3) adjacents, se trouve un élément photovoltaïque (5).

5. Textile d'ombrage selon l'une des revendications précédentes, dans lequel les lamelles photovoltaïques (1) comprennent au moins un film (6) s'étendant dans la direction de la trame (L), constitué d'un matériau électro-conducteur, au moins un élément photovoltaïque (5) étant en contact électrique sur la lamelle photovoltaïque (1) avec le film (6).

6. Textile d'ombrage selon l'une des revendications 1 à 4, dans lequel la lamelle photovoltaïque (1) comprend une bande textile (7) avec au moins un fil électro-conducteur (8) s'étendant dans la direction de la trame (K) du textile d'ombrage, au moins un élément photovoltaïque (5) de la lamelle photovoltaïque (1) étant en contact électrique avec le fil électro-conducteur (8).

7. Textile d'ombrage selon l'une des revendications précédentes, dans lequel les lamelles photovoltaïques (1) comprennent des films photovoltaïques élastiquement déformables.

8. Textile d'ombrage selon l'une des revendications précédentes, dans lequel les lamelles photovoltaïques (1) comprennent une lamelle de support sur laquelle l'au moins un film photovoltaïque est fixé, par exemple collé.

9. Textile d'ombrage selon la revendication 8, dans lequel le film photovoltaïque entoure la lamelle de support à partir d'un côté supérieur de la lamelle de support autour d'arêtes longitudinales de la lamelle de support vers un côté inférieur de la lamelle de support.

10. Textile d'ombrage selon l'une des revendications précédentes, dans lequel le système de fils (2), dans la direction dans laquelle le textile d'ombrage est conçu de manière élastique, peut être tendu de manière élastique et présente une précontrainte opposée à cette direction, de façon à ce que les ouvertures qui ne se forment que lors de la tension du textile d'ombrage soient fermées lorsque le textile d'ombrage n'est pas tendu.

11. Multiple vitrage dans lequel est logé un textile d'ombrage selon l'une des revendications précédentes dans un espace intermédiaire entre les vitres.

12. Multiple vitrage selon la revendication 11, dans lequel le textile d'ombrage est guidé linéairement, dans la direction dans laquelle il est conçu de manière élastique, dans l'espace intermédiaire entre les vitres, entre une première et une deuxième position, moyennant quoi, au niveau d'une extrémité de traction du textile d'ombrage, se trouve un premier aimant et, à l'extérieur de l'espace intermédiaire entre les vitres, se trouve un deuxième aimant, ces aimants étant couplés de manière fonctionnelle.

13. Multiple vitrage selon l'une des revendications 11 ou 12, dans lequel le deuxième aimant peut coulisser le long d'un guidage linéaire dans la direction dans laquelle le textile d'ombrage est conçu de manière élastique.
